# EUROPÄISCHE PATENTSCHRIFT

(11) **EP 2 964 584 B1**
(45) Veröffentlichungstag und Bekanntmachung des Hinweises auf die Patenterteilung: **04.09.2019**
(21) Anmeldenummer: 14707417.3
(22) Anmeldetag: 03.03.2014
(51) Int. Cl.: C03C 17/00, C03C 17/22, C03C 17/34, C23C 14/34, C23C 14/35

(54) **KRATZFESTER GLASGEGENSTAND**
SCRATCH-RESISTANT GLASS OBJECT
OBJET EN VERRE INRAYABLE

(30) Priorität: 06.03.2013 DE 102013102221
(43) Veröffentlichungstag der Anmeldung: 13.01.2016
(73) Patentinhaber: Schott AG, 55122 Mainz (DE)
(72) Erfinder: DAMM, Thorsten, 55268 Nieder-Olm (DE); HENN, Christian, 55546 Frei-Laubersheim (DE)
(74) Vertreter: Blumbach · Zinngrebe Patentanwälte PartG mbB
(86) Internationale Anmeldenummer: PCT/EP2014/054059
(87) Internationale Veröffentlichungsnummer: WO 2014/135490

(56) Entgegenhaltungen:
- EP-A2- 0 327 888
- DE-A1-102007 033 338
- DE-B3-102010 032 892

## Beschreibung

Die Erfindung bezieht sich auf einen kratzfesten Glasgegenstand sowie auf ein Verfahren zur Herstellung kratzfester Oberflächen von Glasgegenständen.

Ein magneto-optisches Speichermedium ist aus EP 0 233 062 A2 bekannt und umfasst unter Anderem ein Glassubstrat, darauf eine Schutzschicht, darauf die Magneto-optische Speicherschicht und darauf wiederum eine Schutzschicht. Die Schutzschicht enthält die Komponenten Si, Al, O und N in diversen Verbindungen, darunter auch AlSiN und AlN. Aus EP 0 327 888 ist ein Verfahren zur Herstellung einer dünnen röntgenamorphen Aluminiumsnitrid- oder Aluminiumsiliciumnitrid-Schicht auf einer Oberfläche bekannt, bei der die reaktive Kathodenzerstäubung oder die reaktive Magnetronkathodenzerstäubung von Aluminium und von Silicium im Vakuum in einer Edelgas und Stickstoff enthaltenden Prozessgasatmosphäre und Abscheiden der Schicht aus der Gasphase angewendet wird. Als Anwendungsgebiet sind Schutzschichten in flächenförmigen, mehrschichtigen laseroptischen und magneto-optischen Aufzeichnungsmaterialien genannt, auch Glas ist als mögliches, zu beschichtende Material erwähnt. Zu Kratzfestigkeit und besseren Gleiteigenschaften der Oberflächenschicht gibt es keine Offenbarung.

Die Herstellung einer dünnen röntgenamorphen Aluminiumnitrid- oder Aluminiumsiliziumnitrid-Deckschicht ist aus der US 4,957,604 bekannt, wobei Verfahrensparameter zum Sputter-Verfahren angegeben werden.

Aus EP 1 705 162 A1 ist eine zweiphasige Beschichtung großer Härte als Matrix aus einer kristallinen Substanz und einer amorphen Substanz bekannt, die gleichzeitig auf einem Substrat abgeschieden werden und dadurch innig vermischt sind. Die Schicht ist wenigstens gegenüber sichtbarem Licht transparent. Die amorphe Substanz ist Siliziumnitrid Si₃N₄. Als kristalline Substanz werden Aluminiumnitrid AlN, Bohrnitrid BN, Galliumnitrid GaN und Indiumnitrid InN sowie deren Legierungen genannt. Die Schichten haben einen niedrigen Ausdehnungs-Koeffizienten, wodurch es bei Applikation der Schichten auf thermisch stark dehnenden Substraten, wie zum Beispiel Fensterglas, zur Rissbildung und Ablösungserscheinungen kommt.

Aus DE 10 2007 033 338 B4 ist ein mit Hartstoff beschichteter Glas- oder Glaskeramik-Artikel bekannt, auf dessen Glassubstrat oder Glaskeramiksubstrat eine Siliziumnitridschicht abgeschieden ist, die im Volumen eine röntgenamorphe Morphologie aufweist. Die Siliziumnitridschicht wird durch Sputtern bei einer Leistung > 10 Watt/cm², bevorzugt zumindest 12 Watt/cm² Targetfläche, abgeschieden. Die Siliziumnitridschicht kann mit 5 bis 10 at% Aluminium im Silizium dotiert sein. Es wurden Vickers-Härtegrade zwischen 2000 und 3000 gemessen. In der Praxis hat sich aber herausgestellt, dass die Beschichtung nicht zufriedenstellend chemisch stabil ist. Dieser Mangel zeigt sich bei der Anwendung als Schutzschicht einer Kochfläche, wenn Salzwasser auf die Oberfläche gerät und bei 400 bis 600 °C verdampft wird. Es werden SiN-Bindungen aufgebrochen und es entstehen Stellen mit SiO, wo sich Na-Ionen anlagern können, was mit einer auffälligen optischen Veränderung der Schicht bei diesem Einbrand von Wasser einhergeht. Ein weiterer Nachteil der mit Al dotierten Schicht besteht in der Gefahr der Ablösung, wenn auf ein Substrat aufgebracht, das einen relativ hohen thermischen Ausdehnungs-Koeffizienten (CTE)im Verhältnis zu dem niedrigen thermischen Ausdehnungskoeffizienten der Dotierungsschicht aufweist.

Aus DE 10 2010 032 892 B3 ist ein beschichtetes Produkt bekannt, das schichtweise aus einem Substrat einer Barriereschicht, einer Funktionsschicht und einer Deckschicht aufgebaut ist. Die Barriereschicht aus SiO₂, Al₂O₃ wird durch eine HPPM-Sputterverfahren hergestellt. Während mit SiN-Beschichtungen, auch mit AlN dotiert, sich sehr große Härten erzielen lassen, zeigt sich, dass die Oberflächen bei Betrachtung im Elektronenmikroskop eine rauhe Struktur aufweisen. Solche Oberflächen wirken stumpf und Gegenstände lassen sich nicht einfach über solche Deckschichten ziehen. Dies spiegelt sich in einer erhöhten Haftreibung wider. Dies ist bei Kochfeldern wegen der Verschiebung der Töpfe oder bei Scannerkassen wegen des Darüber-Gleiten-Lassens von Gegenständen von Nachteil.

Der Erfindung liegt die Aufgabe zugrunde, eine transparente Kratzschutzschicht auf Glasgegenständen zu schaffen, die im Vergleich zum erörterten Stand der Technik eine bessere chemische Resistenz gegenüber Salzwassereinbrand aufweist und die eine bessere Gleiteigenschaft gegenüber den darüber geführten Gegenständen aufweist. Die transparente Kratzschutzschicht soll ferner auf Substraten besser haften können, die aus einem umfangreichen Glassortiment ausgewählt werden können. Verglichen mit SiN-Schichtsystemen soll die Kratzschutzwirkung noch verbessert werden.

Unter die Definition "Glasgegenstand" sollen im Rahmen dieser Anmeldung auch Glaskeramikartikel fallen, insbesondere Glaskeramik-Platten für Kochfelder. Weitere Anwendungsmöglichkeiten beziehen sich auf Glasscheiben, die hohen Temperaturbelastungen ausgesetzt sind, wie Kaminsichtscheiben oder Backofenscheiben, sowie auf Scheiben, die auch sehr niedrigen Temperaturen ausgesetzt sind, wie Scheiben von Fahrzeugen, Flugzeugen oder Schiffen. Ein weiteres Anwendungsgebiet betrifft kratzfeste Sichtscheiben und Abdeckungen von zum Beispiel Scannerkassen oder ähnlicher Einrichtungen, bei denen Gegenstände über ein Sichtfenster geschoben werden.

Die Lösung der gestellten Aufgabe erfolgt mit den Merkmalen der unabhängigen Ansprüche.

Gemäß Erfindung wird auf ein Substrat aus Glas oder Glaskeramik eine AlSiN-Deckschicht durch ein Abscheidungsverfahren aufgebracht. Die Deckschicht besteht aus einer röntgenamorphen AlSiN-Schicht mit einem Mischungs-verhältnis von Al:Si in einem Bereich von 20:80 bis 95:05 at%, bevorzugt 40:60 bis 85:15 at%, und höchst bevorzugt 50:50 bis 75:25 at%. Es wird eine Oberflächenrauheit Ra < 1,5 nm, besser Ra < 1,0 nm eingehalten. Dadurch werden die erwünschten Gleiteigenschaften von über die Deckschicht geführten Gegenständen erzielt und außerdem eine gute Kratzschutzwirkung erhalten.

Unter einer AlSiN-Deckschicht wird neben einer reinen AlSiN-Schicht auch eine Schicht verstanden, die in geringerem Maße weitere Schichtbestandteile aufweisen kann. Insbesondere kann eine solche Schicht eine Nitridschicht sein, bei welcher Al und Si gegenüber gegebenenfalls enthaltenen weiteren Komponenten überwiegen. Gemäß der Erfindung stellen bezogen auf die molaren Mengen Al und Si mindestens 2/3 der nitridischen Bestandteile der Schicht.

Ein erfindungsgemäßer kratzfester Glasgegenstand kann in Form einer Glaskeramikplatte für Kochfelder, oder als Glasscheibe für Kamine und Backöfen sowie für Fahrzeuge, Flugzeuge oder Schiffe, oder in Form einer Abdeckung von Scannerkassen, oder in Form eines Sichtfensters oder einer Abdeckung eines Displays ausgebildet sein. Solche Displays können insbesondere auch Touch-Displays sein, wie sie unter anderem für Mobiltelefone, Tablet-PCs und andere handgehaltene elektronische Geräte verwendet werden. Hier wird mit der erfindungsgemäßen Deckschicht eine hohe Kratzfestigkeit und Abnutzungsresistenz erzielt.

An sich können verschiedene Abscheidungsverfahren wie CVD-, Solgel- und PVD-Verfahren zum Herstellen einer AlSiN-Deckschicht angewendet werden. Erfindungsgemäß wird jedoch das HiPIMS-Verfahren (high power impulse magnetron sputtering) verwendet, das auch als HPPMS-Verfahren (high power puls magnetron sputtering) bekannt ist. Dieses Verfahren ermöglicht hohe Leistungsdichten auf dem Target von mindestens 100 Watt/cm² der Targetfläche. Ein bevorzugter Leistungsbereich liegt zwischen 100 und 2000 Watt/cm². Die Wiederholungsfrequenz der Pulse liegt im Bereich zwischen 500 Hz und 10 KHz. Die Impulse können auch als Impulsserien zwischen Impulspausen abgegeben werden. Optional kann während der Pulspausen im Anschluss an die Pulsserien zwischen Target und Substrat eine elektrische Spannung von einigen 100 Volt aufrechterhalten werden, die eine Gleichspannung oder eine Wechselspannung seien kann, um das Plasma in der Sputteranlage aufrechtzuerhalten. Der Prozessdruck in der Sputteranlage wird auf einem relativ niedrigen Wert gehalten (typisch ≤ 5x10⁻³ mbar), was im Zusammenwirken mit den besprochenen Maßnahmen zu einer sehr dichten und glatten Struktur der abgeschiedenen Schicht aus AlSiN führt.

Ausführungsbeispiele der Erfindung werden anhand der Zeichnungen beschrieben. Dabei zeigt:
- Fig. 1: eine Sputteranlage zur Herstellung der erfindungsgemäßen Deckschicht,
- Fig. 2: ein Rasterbild eines vergrößerten Ausschnittes der erfindungsgemäßen Deckschicht,
- Fig. 3: ein Rasterbild einer Deckschicht des Standes der Technik,
- Fig. 4: Darstellung eines Zusammenhanges zwischen Defektfläche und Rauheitswerte bei der erfindungsgemäßen Deckschicht,
- Fig. 5: Darstellung der Haftreibung auf Glaskeramik, auf einer Al-dotierten SiN-Schicht und an einer erfindungsgemäßen Deckschicht,
- Fig. 6: Röntgenbeugungsdiagramme an erfindungsgemäßen Deckschichten,
- Fig. 7: Röntgenbeugungsdiagramme an Schichten des Standes der Technik,
- Fig. 8: ein Diagramm über Defektanzahlen bei der erfindungsgemäßen Deckschicht,
- Fig. 9: ein Diagramm der Defektanzahl bei einer Deckschicht des Standes der Technik,
- Fig. 10: ein Diagramm des spektralen Reflektionsgrades bei einer erfindungsgemäßen Deckschicht,
- Fig. 11: ein Diagramm des spektralen Reflektionsgrades bei einer Deckschicht des Standes der Technik, und
- Fig. 12 bis Fig. 14: verschiedene Ausführungsbeispiele erfindungsgemäßer beschichteter Glasgegenstände.

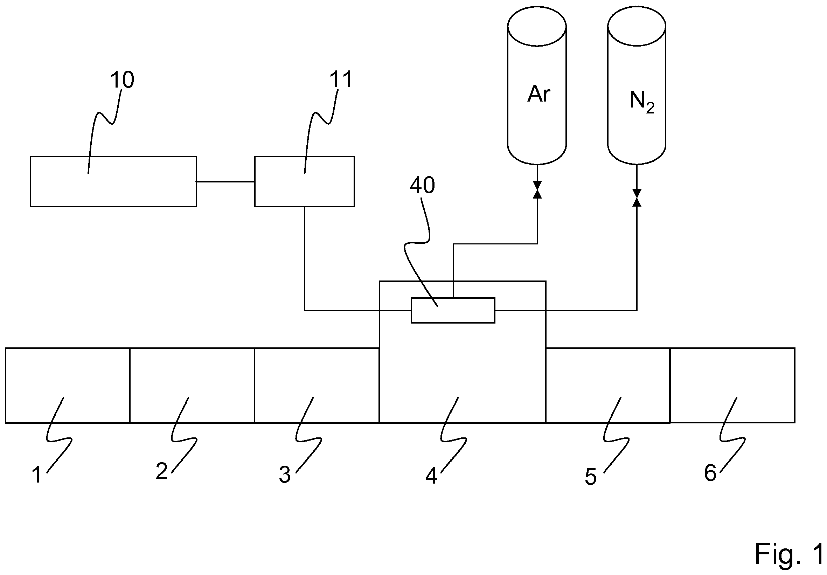

Fig. 1 stellt das Schema einer Sputteranlage dar. Es gibt eine durch die Anlage führende Transporteinrichtung, die an einer Bestückungseinrichtung 1 mit Substraten bestückt wird. Die Substrate gelangen in eine Einschleusekammer 2, die auf Vakuumniveau (< 1x10⁻⁴ mbar)evakuiert wird. Anschließend wird das Substrat in eine Heizkammer 3 verfrachtet, die ebenfalls evakuiert ist und verbleibt dort bei einer definierten Temperatur (z.B. 300 °C) für eine vorbestimmte Zeit. Danach wird das Substrat in eine Prozesskammer 4 verbracht, die wenigstens ein Target 40 mit den zu sputternden Materialen aufweist. Im Falle der Erfindung werden Legierungstargets aus Al und Si im Mischungsverhältnis von 20:80 bis 95:05 at%, bevorzugt 40:60 bis 85:15 at%, und höchst bevorzugt 50:50 bis 75:25 at% Al:Si verwendet. Das oder die Targets sind bei 40 symbolisiert. In die Prozesskammer 4 wird Prozessgas eingelassen, typischerweise Argon (Ar), so dass sich dort ein typischer Prozessdruck im Bereich von 1,0 x 10⁻³ bis 5,0 x 10⁻³ mbar einstellt. An das Target wird eine negative Spannung angelegt, um ein Plasma in der Prozesskammer zu zünden. Dadurch wird ein Sputter-Vorgang ausgelöst, der zum Transport von Material aus den Targets auf das Substrat hin führt. Es kann mit einer mittleren Leistungsdichte von etwa 10 W/cm² gefahren werden. Das als HiPIMS-Verfahren bekannte Sputter-Verfahren mit hoher Leistungsdichte wird angewandt. Während des Sputterns wird Stickstoff (N) als Reaktivgas geregelt zugeführt, so dass sich auf dem Substrat eine AlSiN Deckschicht bildet. Bei dieser Verfahrensweise kann das Substrat immer wieder an dem Target oder den Targets vorbeigefahren werden, bis die gewünschte Schichtdicke erreicht ist.

Alsdann wird das beschichtete Substrat durch eine Ausschleusekammer 5 gefahren, die nach Abdichtung gegenüber der Prozesskammer 4 belüftet wird, wonach das Produkt durch eine Entnahmeeinrichtung 6 entnommen wird.

Die Skizze gemäß Fig. 1 zeigt noch schematisch ein Netzteil und Pulseinheit 10 sowie eine Steuerung 11, die für die geregelte Zuführung der zwischen Target und Substrat bzw. Substrathalter angelegte Spannung zuständig ist. Weitere Details einer Sputteranlage sind dem Fachmann bekannt und werden in Fig. 1 nicht dargestellt.

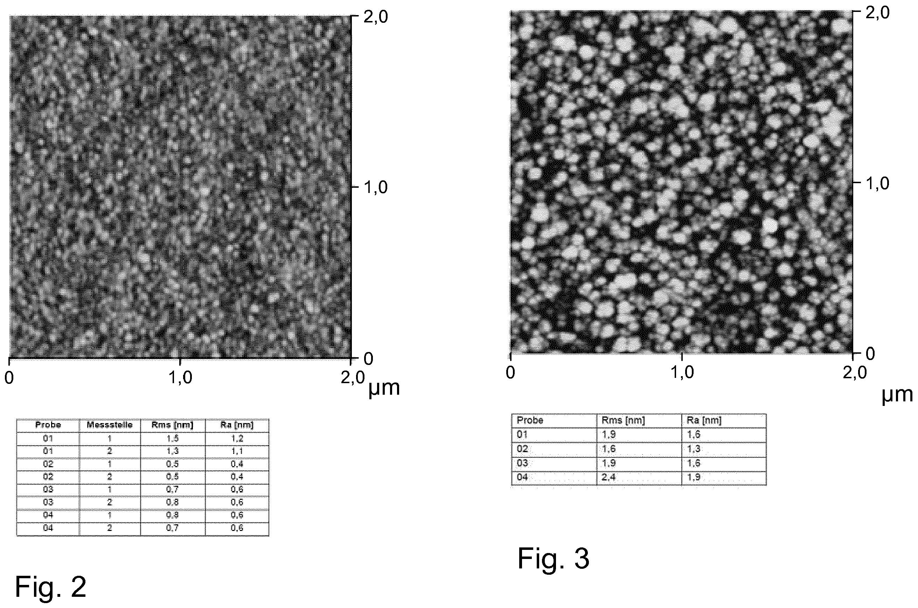

Fig. 2 zeigt einen quadratischen Ausschnitt der Größe 2 µm auf 2 µm der beschichteten Seite eines erfindungsgemäßen Gegenstandes, bei dem die Deckschicht ein Al:Si Verhältnis von ungefähr 50:50 at% aufweist. Die Hell-Dunkel-Werte bilden eine Skala von 10,0 nm bis 0,0 nm ab. Die Fig. 2 umfasst eineTabelle mit Messwerten für die mittlere Rauheit Ra [nm], die von 0,4 bis 1,2 nm reichen, sowie von der mittleren quadratischen Abweichung RMS [nm], die von 0,5 bis 1,5 nm reichen. Die Werte wurden mit einem Atom-Kraft-Mikroskop (AFM) gewonnen. Die Topographie der Schicht ist also außerordentlich glatt und eben. Je glatter die Schicht, desto weniger Angriffspunkte werden einem äußeren Gegenstand, zum Beispiel einem Abrasivpartikel entgegengestellt. Glatte Oberflächen sind aus diesem Grunde kratzfester als rauhe Oberflächen der gleichen Oberflächenhärte. Der Fremdkörper kann an der glatten Oberfläche einfach abgleiten und bleibt nicht an einer Erhöhung oder Vertiefung der Schichtoberfläche hängen. Aus Vergleichsversuchen hat sich ergeben, dass bei der Rauheit von Ra > 1,5 nm es zu einer signifikanten Erhöhung der Kratzeranfälligkeit führt. Daher sind insbesondere Schichten mit einer Rauheit von Ra < 1,5 nm, besser mit einer Ra < 1,0 nm besonders kratzerunauffällig.

Fig. 3 zeigt einen Ausschnitt von 2 µm auf 2 µm einer Vergleichsprobe mit einer Schicht von SiN mit einer Al-Dotierung von 10 at%. Auch diese Probe wurde mit einem Atomkraftmikroskop abgetastet. Die Hell-Dunkel-Werte bilden eine Skala von 15,0 nm bis 0,0 nm ab.Gemessene Rauheitswerte RMS und Rauheit Ra finden sich neben der topographischen Darstellung. Die mittlere Rauheit Ra reicht von 1,3 bis 1,9 nm und die mittlere quadratische Rauheit RMS reicht von 1,6 bis 2,4 nm.

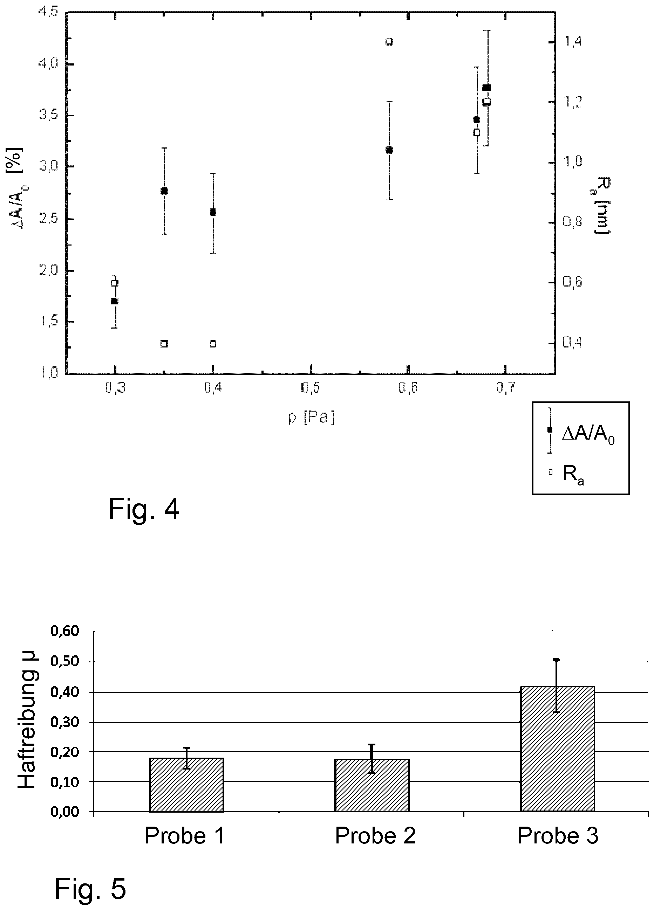

Rauheitswerte beeinflussen auch die Größe der Defektflächen der Deckschichten. Fig. 4 gibt einen Zusammenhang zwischen Defektfläche und Rauheitswerte von ALSiN-Deckschichten mit einem Al:Si-Verhältnis von ungefähr 50:50 at% an. Die Abszisse zeigt den Prozessgasdruck p in [Pa], während die linke Ordinate die relative Defektfläche ΔA/A₀ in % und die rechte Ordinate die mittlere Ra in nm angibt. Das Diagramm zeigt, dass ein niedriger Prozessgasdruck zur Erzielung von niedrigen Rauheitswerten günstig ist.

Für den Einsatz der AlSiN-Deckschichten im Bereich Kochfeld ist es wichtig, dass sich die Töpfe leicht über das Kochfeld schieben lassen. Solche Töpfe bestehen insbesondere aus Edelstahl. Fig. 5 zeigt ein Blockdiagramm der Haftreibung µ gegenüber Edelstahl bei unterschiedlichen Kochfeldausbildungen. Die linke Probe 1 bezieht sich auf eine unbeschichtete Glaskeramik, die mittlere Probe 2 auf eine AlSiN-Deckschicht auf Glaskeramik und die rechte Probe 3 auf eine SiN-Schicht mit 10 at% Al-Dotierung auf Glaskeramik. Die Blöcke stellen die Mittelwerte aus mehreren Messungen dar. Wie aus der Darstellung ersichtlich, sind aluminiumdotierte SiN-Beschichtungen gemäß DE 10 2007 033 338 B4 hinsichtlich Haftreibung im Einsatzgebiet Kochfeld weniger günstig als es die erfindungsgemäße Beschichtung ist.

Hinsichtlich der Beschichtung mit aluminiumdotiertem SiN gibt es noch einen weiteren Nachteil bei der Anwendung im Kochfeld, nämlich die Gefahr des Salzwassereinbrandes in die Kochfläche. Wenn nämlich Salzwasser auf der Kochfläche verdampft wird, bricht das Wasser die Bindungen zwischen Si und N auf, es können sich SiO- Stellen bilden, an denen sich Na-Ionen anlagern können. Dies führt zu einer auffälligen optischen Veränderung der SiN-Schicht auf der Kochfläche, was unerwünscht ist.

Wie bereits oben erwähnt, kann die erfindungsgemäße AlSiN-Beschichtung auch noch weitere Schichtbestandteile enthalten. Dabei überwiegen Al und Si aber gegenüber gegebenenfalls enthaltenen weiteren Komponenten. Ohne Beschränkung auf die dargestellten Ausführungsbeispiele können diese Schichtbestandteile Carbide und/oder Nitride und/oder Carbonitride und/oder Oxide zumindest eines der Elemente Bor, Titan, Chrom, Zirkon, Hafnium und Kohlenstoff umfassen. Um die vorteilhaften Eigenschaften der erfindungsgemäßen Beschichtung zu erhalten, sind diese Schichtbestandteile bevorzugt zu höchstens 1/3 enthalten (so dass Al und Si mindestens 2/3 der nitridischen und oxidischen Komponenten stellen). Vorzugsweise sind diese Schichtbestandteile zu höchstens 1/4, besonders bevorzugt höchstens 15% des molaren Gesamtgehalts an Al und Si enthalten. Die oben genannten Schichtbestandteile können zusätzlich zum geringen Haftreibungswert der erfindungsgemäßen Schicht gegenüber Edelstahl auch die Gleitreibung vorteilhaft erniedrigen. Damit wird auch der Verschleißschutz verbessert.

Carbide und Carbonitride können weiterhin zusätzlich zur Absenkung der Lichttransmission eingesetzt werden.

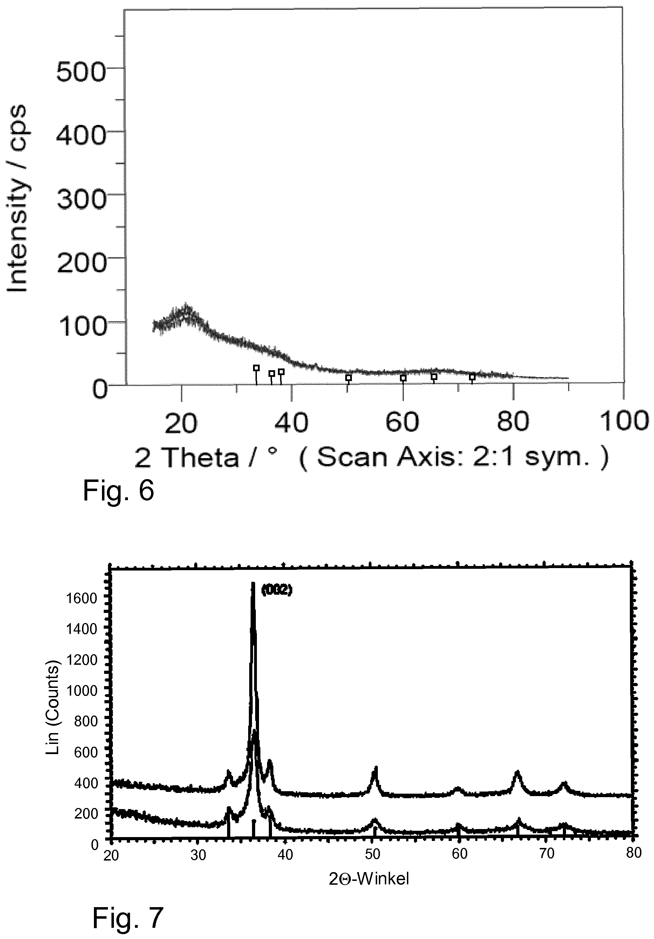

Zur Erzielung der geringen Rauheitswerte bei der Erfindung trägt auch die Tatsache bei, dass die AlSiN-Schicht unter den erfindungsgemäßen Herstellungsbedingungen amorph vorliegt. Dies wird mit Fig. 6 bewiesen, die ein Röntgenbeugungsdiagramm zeigt. Der Einstrahlwinkel des Röntgenstrahls entspricht der Vorzugsrichtung (100). Die Abszisse betrifft den Öffnungswinkel der Röntgenbeugung 2-Theta. Die Ordinate gibt Zählereignisse wieder. In dem Diagramm sind ferner Fähnchen (aufragende Striche mit Quadrat am Ende) eingezeichnet, welche die Theta-Positionen von Röntgen-Beugungserscheinungen bei AlN-Kristallen wiedergeben, wenn solche in der Probe feststellbar sind. Wenn es also erhöhte Zählwerte an allen mit Fähnchen markierten Stellen gäbe, könnte man davon ausgehen, dass in der Probe sich AlN-Kristallite befinden. Fig. 6 zeigt jedoch, dass bei den erfindungsgemäßen Herstellungsbedingungen sich Deckschichten erzeugen lassen, die frei von AlN-Kristalliten sind. Mithin ist die erfindungsgemäße Deckschicht auch röntgenamorph. Die außerordentliche Glattheit der Oberfläche der erzeugten AlSiN-Deckschicht ist nicht zuletzt dem Fehlen von AlN-Kristalliten zu verdanken.

Fig. 7 zeigt Röntgenbeugungsdiagramme von kristallinen/amorphen zweiphasigen Deckschichten aus SiN/AlN gemäß EP 1 705 162 A1. Auf der Abszisse sind wiederum die 2-Theta-Stellen markiert, die sich beim Auftreten von kristallinem AlN als Spitzenzählwerte bemerkbar machen. Wie die Grafik zeigt, kann in den Proben ein kristalliner AlN-Anteil nachgewiesen werden.

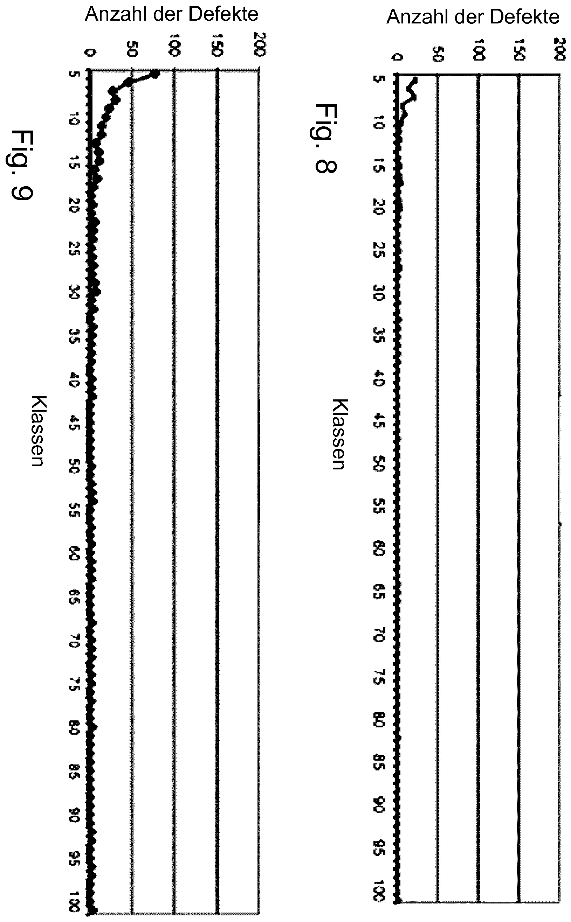

Die geringe Schichtrauheit der erfindungsgemäßen AlSiN-Deckschicht ist für die geringe Anzahl der Defekte nach Durchführung des Applikationstests, klassifiziert nach Defektgrößen, verantwortlich. Fig. 8 zeigt eine bildliche Darstellung der Anzahl der Defekte bezüglich Defektklassen für die AlSiN-Deckschicht gemäß Erfindung, und Fig. 9 zeigt eine solche Darstellung für eine aluminiumdotierte SiN-Schicht bei 10 at% Al-Dotierung. Mit etwa 25 Defekten einer Klassengröße von 5 sowie fehlenden Defekten bei Übersteigen der Klassengröße 12 bietet die AlSiN-Deckschicht gemäß Erfindung eine wesentlich bessere Kratzschutzwirkung als die mit Al-dotierte SiN-Schicht nach Fig. 9. Bei dieser gibt es etwa 80 Defekte der Klassengröße 5 und die Anzahl der Defekte fallen erst bei etwa der Klassengröße 20 auf Null zurück.

Die Klassengröße der Defekte korrespondiert zur Fläche der Defekte. Im Speziellen bezieht sich die Klassengröße auf die Anzahl der Pixel einer Auswertekamera. Die Pixel weisen eine Größe von ca. 25 µm x 25 µm auf. Demgemäß beinhaltet als Beispiel die Klassengröße 5 Defekte mit einer Kantenlänge von maximal 125 µm.

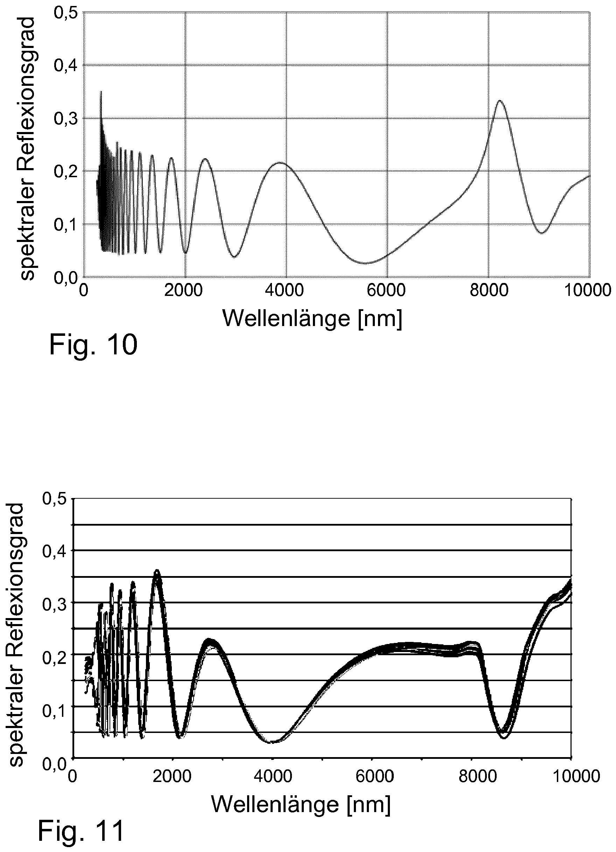

Bei Kochfeldern wird häufig ein Dekor aufgedruckt, das zusammen mit der schwarzen Glaskeramik durch die Deckschicht gut wahrnehmbar sein sollte. Aus diesem Grund ist es wünschenswert, wenn die Beschichtung im sichtbaren Bereich möglichst gering reflektiert und absorbiert. Die Brechzahlen der Schicht sollten möglichst klein sein. Fig. 10 zeigt im sichtbaren und im Infrarotbereich des Lichtes den spektralen Reflektionsgrad über die Wellenlänge für die AlSiN-Deckschicht gemäß Erfindung und in Fig. 11 für eine Si₃N₄-Schicht gemäß DE 10 2007 033 338 B4. Der Reflektionsgrad der erfindungsgemäßen AlSiN-Schicht (Fig. 10) ist generell niedriger als der Reflektionsgrad der Si₃N₄-Schicht nach dem Stand der Technik (Fig. 11) und liegt im sichtbaren Bereich in den Spitzenwerten nahe bei 0,2 während im Falle der Fig. 11 die Spitzenwerte im sichtbaren Bereich teilweise bei 0,30 und 0,35 liegen Vorteilhaft bei der Herstellung einer erfindungsgemäßen Beschichtung ist die Verwendung eine Substratheizung, um das Substrat vor oder während der Beschichtung auf eine erhöhte Temperatur zu bringen, die das Ausbilden einer dichten Schicht erleichtert. Die Heizung kann über einfache Strahlungsheizer realisiert werden. Alternativ kann ein Heizen über gepulste Verfahren, wie beim Blitzlampen-Tempern hilfreich sein. Ferner können Laser verwendet werden, die auf das Schichtmaterial oder das Substrat abgestimmt sind, um das Substrat vor oder während der Beschichtung zu heizen und dadurch das Abscheiden der Schicht positiv zu beeinflussen.
Die Härte und die Performance der Kratzschutzwirkung einer erfindungsgemäßen Schicht kann auch durch eine Behandlung im Anschluss an deren Herstellung verbessert werden. Neben einer einfachen thermischen Behandlung in einem Ofen können weiterhin Blitzlampen-Heizen oder eine Behandlung mittels Laser angewendet werden.

Zusammenfassend kann festgestellt werden, dass mit der Erfindung eine kratzfeste amorphe und transparente AlSiN-Deckschicht geschaffen wird, deren Oberflächenrauheit bemerkenswert niedrig ist, die dadurch ausgezeichnete Gleiteigenschaften gegenüber Töpfen und anderen Gegenständen aufweist. Die Deckschicht ist im sichtbaren Licht und weitgehend auch im infraroten Bereich transparent und zeigt eine gute chemische Resistenz gegenüber Salzwassereinbrand. Soll die Deckschicht eine geringere Lichttransmission aufweisen, kann die AlSiN-Schicht auch Carbide oder Carbonitride zumindest eines der Elemente Bor, Titan, Chrom, Zirkon, Hafnium enthalten.

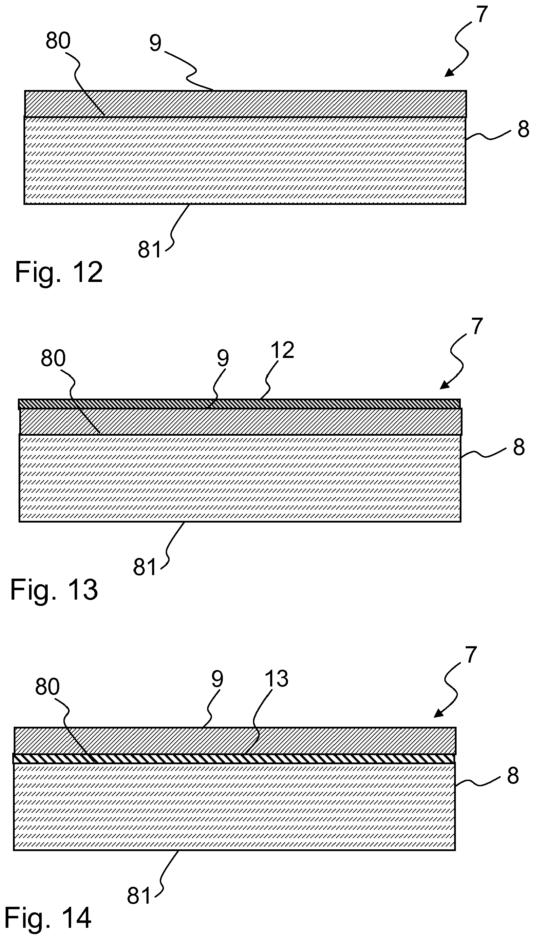

Im folgenden werden einige Ausführungsformen erfindungsgemäßer Glasgegenstände beschrieben. Fig. 12 zeigt im Querschnitt eine Grund-Ausführungsform der Erfindung. Bevorzugt wird für einen erfindungsgemäßen Glasgegenstand 7 ein flächiges oder scheibenförmiges Substrat 8 aus Glas oder Glaskeramik mit Seiten 80, 81 verwendet. Auf zumindest einer der Seiten, bei dem gezeigten Beispiel auf Seite 80 ist eine erfindungsgemäße AlSiN-Deckschicht 9 abgeschieden. Die Schichtdicke der AlSiN-Deckschicht 9 liegt im Bereich von 0,5 µm - 5 µm, bevorzugt 0,5 - 2 µm. Vorzugsweise wird mindestens eine Nutzseite beschichtet. Demgemäß wäre die bei einem Glasgegenstand 7 in Form einer Glaskeramik-Platte eines Glaskeramik-Kochfelds die beschichtete Seite 80 die Oberseite der Glaskeramik-Platte. Bei einem Glasgegenstand 7 in Form einer Display-Abdeckung, etwa für einen Touch-Bildschirm stellt die Seite 80 mit der Deckschicht 9 entsprechend die dem Nutzer zugewandte Außenseite der Abdeckung dar.

Gemäß einer Ausführungsform der Erfindung kann, wie im Beispiel der Fig. 13 gezeigt, zusätzlich zur Deckschicht 9 auch noch eine Abschlussschicht 12 vorhanden sein. Die Abschlußschicht 12 ist dabei auf der Deckschicht 9 abgeschieden. Die Abschlußschicht 12 kann insbesondere zur Veränderung der optischen Eigenschaften oder der Reibeigenschaften dienen. Geeignet als Materialien für die Abschlussschicht sind insbesondere einer oder mehrere Stoffe aus der Gruppe der Oxide, Nitride, Carbonitride oder Oxinitride zumindest eines der Elemente Aluminium, Silizium, Bor, Zirkon, Titan, Chrom, Nickel.

Unter Umständen kann eine solche Deckschicht 12 abhängig von deren Schichtdicke auch eine Verschlechterung der mechanischen Eigenschaften der Beschichtung insgesamt mit sich bringen.

Es wird daher bevorzugt, diese Abschlussschicht 12 dünn zu halten. Allgemein, ohne Beschränkung auf das dargestellte Ausführungsbeispiel ist daher gemäß einer Ausführungsform der Erfindung vorgesehen, dass auf der AlSiN-Deckschicht 9 eine Abschlussschicht 12 abgeschieden ist, deren Schichtdicke geringer ist, als die Schichtdicke der AlSiN-Deckschicht 9. Besonders bevorzugt liegt die Schichtdicke einer solchen Abschlussschicht 12 im Bereich von 1 bis 500 Nanometern, insbesondere bevorzugt im Bereich von 1 bis 200 Nanometern.

Gemäß noch einer Ausführungsform kann auch eine Zwischenschicht 13 abgeschieden werden. Fig. 14 zeigt dazu ein Ausführungsbeispiel. Die AlSiN-Deckschicht wird auf der zuvor abgeschiedenen Zwischenschicht 13 abgeschieden. Zweck der Zwischenschicht 13 ist es, die Haftung der Deckschicht 9 zu verbessern. Auch die Zwischenschicht 13 wird vorzugsweise dünn gehalten. Die Zwischenschicht 13 weist gemäß einer Weiterbildung eine Schichtdicke im Bereich von 1 bis 500 Nanometern, bevorzugt im Bereich von 1 bis 200 Nanometern, insbesondere bevorzugt im Bereich von 1 bis 50 Nanometern auf. Ebenso wie bei der Abschlussschicht 12 sind als Materialien für die Zwischenschicht insbesondere einer oder mehrere Stoffe aus der Gruppe der Oxide, Nitride, Carbonitride oder Oxinitride zumindest eines der Elemente Aluminium, Silizium, Bor, Zirkon, Titan, Chrom, Nickel geeignet.

### Bezugszeichenliste:

- 1: Bestückungseinrichtung
- 2: Einschleusekammer
- 3: Heizkammer
- 4: Prozesskammer
- 5: Ausschleusekammer
- 6: Entnahmeeinrichtung
- 7: Glasgegenstand
- 8: Substrat
- 9: Deckschicht
- 10: Netzteil und Pulseinheit
- 11: Steuerung
- 12: Abschlussschicht
- 13: Zwischenschicht
- 40: Target
- 80, 81: Seiten von 8

## Patentansprüche

1. Kratzfester Glasgegenstand (7), umfassend:
- ein Substrat (8) aus Glas oder Glaskeramik, und
- eine durch Abscheidung auf dem Substrat aufgebrachte Deckschicht (9)
- aus röntgenamorphem AlSiN mit einem Mischungsverhältnis von Al:Si in einem Bereich von 20:80 bis 95:05 at%, bevorzugt 40:60 bis 85:15 at%, und höchst bevorzugt 50:50 bis 75:25 at%, wobei bezogen auf die molaren Mengen Al und Si mindestens 2/3 der nitridischen Bestandteile der Deckschicht (9) stellen, und
- mit einem molaren Restanteil in der Deckschicht (9),
- mit einer Oberflächenrauheit Ra < 1,5 nm, besser Ra < 1,0 nm.

2. Kratzfester Glasgegenstand (7) nach Anspruch 1, wobei die AlSiN-Deckschicht (9) transparent gegenüber sichtbarer und infraroter Strahlung ist.

3. Kratzfester Glasgegenstand Anspruch 1 oder 2, wobei die Härte der Deckschicht (9) über 15 GPa, bevorzugt über 20GPa, besonders bevorzugt über 25 GPa liegt.

4. Kratzfester Glasgegenstand nach einem der Ansprüche 1 bis 3, wobei die Deckschicht (9) eine Haftreibung µ gegenüber Metallkörper µ < 0,25 aufweist.

5. Kratzfester Glasgegenstand nach einem der Ansprüche 1 bis 4, wobei die Deckschicht (9) einen mittleren Reflektionsgrad kleiner 0,15 im sichtbaren Bereich des Lichts aufweist.

6. Kratzfester Glasgegenstand nach einem der Ansprüche 1 bis 5, wobei die Schichtdicke der Deckschicht im Bereich von 0,5 µm - 5 µm, bevorzugt 0,5 - 2 µm liegt.

7. Kratzfester Glasgegenstand nach einem der Ansprüche 1 bis 6, wobei die Deckschicht (9) zumindest ein Carbid, Nitrid, Carbonitrid oder Oxid zumindest eines der Elemente Bor, Titan, Chrom, Zirkon, Hafnium und Kohlenstoff enthält.

8. Kratzfester Glasgegenstand nach einem der Ansprüche 1 bis 7, umfassend eine auf der Deckschicht (9) abgeschiedene Abschlussschicht (12), deren Schichtdicke geringer ist als die Schichtdicke der Deckschicht (9), wobei die Abschlussschicht (12) einen oder mehrere Stoffe aus der Gruppe der Oxide, Nitride, Carbonitride oder Oxinitride zumindest eines der Elemente Aluminium, Silizium, Bor, Zirkon, Titan, Chrom oder Nickel enthält.

9. Kratzfester Glasgegenstand nach einem der Ansprüche 1 bis 8, umfassend eine Zwischenschicht (13), deren Schichtdicke geringer ist als die Schichtdicke der Deckschicht (9), wobei die Deckschicht (9) auf der Zwischenschicht (13) abgeschieden ist, und wobei die Zwischenschicht (13) einen oder mehrere Stoffe aus der Gruppe der Oxide, Nitride, Carbonitride oder Oxinitride zumindest eines der Elemente Aluminium, Silizium, Bor, Zirkon, Titan, Chrom oder Nickel enthält.

10. Kratzfester Glasgegenstand nach einem der Ansprüche 1 bis 9, in Form einer Glaskeramikplatte für Kochfelder, oder als Glasscheibe für Kamine und Backöfen sowie für Fahrzeuge, Flugzeuge oder Schiffe, oder in Form einer Abdeckung von Scannerkassen, oder in Form eines Sichtfensters oder einer Abdeckung eines Displays.

11. Verfahren zur Herstellung kratzfester Oberflächen von Glasgegenständen, mit folgenden Schritten:
a) Bereitstellen eines Substrats (8) aus Glas oder Glaskeramik in einer Sputtervorrichtung mit LegierungsTargets aus Al und Si im Mischungsverhältnis von 20:80 bis 95:05 at%, bevorzugt 40:60 bis 85:15 at%, und höchst bevorzugt 50:50 bis 75:25 at% Al:Si;
b) Abgabe von gesputterten Partikel mit einer Leistung im Bereich von 10 bis 2000 W/cm² pro Targetfläche bei einem Prozessdruck im Bereich von 0,01 bis 1.5 [Pa];
c) Anwenden des HiPIMS-Verfahrens (High Power Impulse Magnetron Sputtering) als Sputterverfahren in Kombination mit Aufrechterhaltung des Plasmas während Impulspausen und hierzu Aufrechterhalten einer negativen Spannung oder einer Wechselspannung zwischen Target und Substrat (8), wobei während des Sputterns Stickstoff als Reaktivgas geregelt zugeführt wird; und
d) Führen des Verfahrens derart, dass röntgenamorphes AlSiN, wobei bezogen auf die molaren Mengen Al und Si mindestens 2/3 der nitridischen Bestandteile der Schicht stellen, in einer Deckschicht (9) auf dem Substrat (8) abgeschieden wird.

12. Verfahren nach Anspruch 11, wobei das Substrat (8) vor oder während der Beschichtung auf eine erhöhte Temperatur gebracht wird.

## Claims

1. A scratch-resistant glass article (7), comprising:
- a substrate (8) made of glass or glass ceramic; and
- an cover layer (9) applied on the substrate by deposition,
- of X-ray amorphous AlSiN with an Al:Si mixing ratio in a range from 20:80 to 95:05 at%, preferably from 40:60 to 85:15 at%, and most preferably from 50:50 to 75:25 at%, wherein Al and Si make up at least 2/3 of the nitridic constituents of the cover layer (9) based on the molar amounts, and
- with a molar residual content in the cover layer (9);
- with a surface roughness of Ra < 1.5 nm, better Ra < 1.0 nm.

2. The scratch-resistant article (7) according to claim 1, wherein the AlSiN cover layer (9) is transparent to visible and infrared radiation.

3. The scratch-resistant article according to claim 1 or 2, wherein the cover layer (9) exhibits a hardness of greater than 15 GPa, preferably greater than 20 GPa, more preferably greater than 25 GPa.

4. The scratch-resistant article according to any one of claims 1 to 3, wherein the cover layer (9) exhibits a static friction µ with respect to metallic bodies of µ < 0.25.

5. The scratch-resistant article according to any one of claims 1 to 4, wherein the cover layer (9) exhibits an average reflectance of less than 0.15 in the visible range of light

6. The scratch-resistant article according to any one of claims 1 to 5, wherein the layer thickness of the cover layer is in a range from 0.5 µm to 5 µm, preferably from 0.5 to 2 µm.

7. The scratch-resistant article according to any one of claims 1 to 6, wherein the cover layer (9) includes at least one of a carbide, nitride, carbonitride, or oxide of at least one of the elements boron, titanium, chromium, zirconium, hafnium, and carbon.

8. The scratch-resistant glass article according to any one of claims 1 to 7, comprising a final layer (12) deposited on the cover layer (9), which final layer has a thickness smaller than the thickness of the cover layer (9), wherein the final layer (12) includes one or more substances from the group of oxides, nitrides, carbonitrides, or oxynitrides of at least one of the elements aluminum, silicon, boron, zirconium, titanium, chromium, or nickel.

9. The scratch-resistant glass article according to any one of claims 1 to 8, comprising an intermediate layer (13) that has a thickness smaller than the thickness of the cover layer (9), wherein the cover layer (9) is deposited on the intermediate layer (13), and wherein the intermediate layer (13) includes one or more substances from the group of oxides, nitrides, carbonitrides, or oxynitrides of at least one of the elements aluminum, silicon, boron, zirconium, titanium, chromium, or nickel.

10. The scratch-resistant glass article according to any one of claims 1 to 9, in the form of a glass ceramic panel for cooktops, or as a glass window for fireplaces and ovens, and for vehicles, aircraft, or ships, or in the form of a cover for scanner cash registers, or in the form of a viewing window or a cover of a display.

11. A method for producing scratch-resistant surfaces of glass articles, comprising the steps of:
a) providing a glass or glass ceramic substrate (8) in a sputtering apparatus that includes Al and Si alloy targets in a mixing ratio Al:Si from 20:80 to 95:05 at%, preferably from 40:60 to 85:15 at%, and most preferably from 50:50 to 75:25 at%;
b) releasing sputtered particles at a power in a range from 10 to 2000 W/cm² target surface area at a processing pressure in a range from 0.01 to 1.5 Pa;
c) employing HiPIMS (High Power Impulse Magnetron Sputtering) process as a sputtering method in combination with maintaining the plasma during pulse pauses and for this purpose maintaining a negative voltage or an alternating voltage between the target and substrate (8), while nitrogen is supplied in controlled manner during the sputtering as a reactive gas; and
d) controlling the process such that X-ray-amorphous AISiN is deposited in a cover layer (9) on the substrate (8), wherein, based on the molar amounts, Al and Si make up at least 2/3 of the nitridic constituents of the layer.

12. The method according to claim 11, wherein the substrate (8) is brought to an elevated temperature before or during the coating.

## Revendications

1. Article en verre (7) résistant aux rayures, comprenant :
- un substrat (8) en verre ou vitrocéramique, et
- une couche de revêtement (9) appliquée sur le substrat par dépôt,
- constituée d'AlSiN amorphe aux rayons X avec un rapport de mélange Al : Si compris dans une plage allant de 20 : 80 à 95 : 05 % en atomes, de préférence de 40 : 60 à 85 : 15 % en atomes, et de manière particulièrement avantageuse de 50 : 50 à 75 : 25 % en atomes, où, rapporté aux quantités molaires, Al et Si représentent au moins 2/3 des composants de nitrures de la couche de revêtement (9), et
- avec une fraction molaire résiduelle dans la couche de revêtement (9),
- avec une rugosité de surface Ra < 1,5 nm, de préférence Ra < 1,0 nm.

2. Article en verre (7) résistant aux rayures selon la revendication 1, dans lequel la couche de revêtement AlSiN (9) est transparente au rayonnement visible et infrarouge.

3. Article en verre résistant aux rayures selon la revendication 1 ou 2, dans lequel la dureté de la couche de revêtement (9) est supérieure à 15 GPa, de préférence supérieure à 20 GPa, et de façon particulièrement avantageuse supérieure à 25 GPa.

4. Article en verre résistant aux rayures selon l'une des revendications 1 à 3, dans lequel la couche supérieure (9) présente un frottement par adhérence µ par rapport à des corps métalliques µ < 0,25.

5. Article en verre résistant aux rayures selon l'une des revendications 1 à 4, dans lequel la couche de revêtement (9) présente un facteur de réflexion moyen inférieur à 0,15 dans le domaine visible de la lumière.

6. Article en verre résistant aux rayures selon l'une des revendications 1 à 5, dans lequel l'épaisseur de la couche de revêtement est comprise dans la plage allant de 0,5 µm à 5 µm, de préférence de 0,5 à 2 µm.

7. Article en verre résistant aux rayures selon l'une des revendications 1 à 6, dans lequel la couche de revêtement (9) contient au moins un carbure, un nitrure, un carbonitrure ou un oxyde d'au moins l'un des éléments suivants : bore, titane, chrome, zirconium, hafnium et carbone.

8. Article en verre résistant aux rayures selon l'une des revendications 1 à 7, comprenant une couche de finition (12) déposée sur la couche de revêtement (9), dont l'épaisseur de couche est inférieure à l'épaisseur de couche de la couche de revêtement (9), la couche finale (12) contenant une ou plusieurs substances du groupe des oxydes, nitrures, carbonitrures ou oxynitrures d'au moins un des éléments suivants : aluminium, silicium, bore, zirconium, titane, chrome ou nickel.

9. Article en verre résistant aux rayures selon l'une des revendications 1 à 8, comprenant une couche intermédiaire (13) dont l'épaisseur de couche est inférieure à l'épaisseur de couche de la couche de revêtement (9), la couche de revêtement (9) étant déposée sur la couche intermédiaire (13), et la couche intermédiaire (13) contenant une ou plusieurs substances du groupe des oxydes, nitrures, carbonitrures ou oxynitrures d'au moins un des éléments suivants : aluminium, silicium, bore, zirconium, titane, chrome ou nickel.

10. Article en verre résistant aux rayures selon l'une des revendications 1 à 9, sous la forme d'une plaque en vitrocéramique pour plans de cuisson, ou d'une vitre pour cheminées et fours, ainsi que pour des véhicules, avions ou bateaux, ou sous la forme d'un élément de recouvrement pour caisses enregistreuses, ou sous la forme d'une fenêtre de visualisation ou d'un élément de recouvrement pour un écran.

11. Procédé de fabrication de surfaces résistant aux rayures d'articles en verre, comprenant les étapes suivantes :
a) préparation d'un substrat (8) en verre ou vitrocéramique dans un dispositif de pulvérisation cathodique avec des cibles en alliage d'Al et de Si avec un rapport de mélange allant de 20 : 80 à 95 : 05 % en atomes, de préférence de 40 : 60 à 85 : 15 % en atomes, et de manière particulièrement avantageuse de 50 : 50 à 75 : 25 % en atomes de Al :Si ;
b) émission de particules pulvérisées avec une puissance comprise dans la plage allant de 10 à 2 000 W/cm² par surface cible, à une pression de procédé comprise dans la plage allant de 0,01 et 1,5 [Pa] ;
c) mise en oeuvre du procédé HiPIMS de pulvérisation cathodique magnétron à impulsions de haute puissance, en tant que procédé de pulvérisation, en combinaison avec le maintien du plasma pendant les intervalles entre impulsions et, à cet effet, le maintien d'une tension négative ou d'une tension alternative entre la cible et le substrat (8), avec apport contrôlé d'azote, en tant que gaz réactif, pendant la pulvérisation cathodique ; et
d) conduite du procédé de manière telle que l'AlSiN amorphe aux rayons X soit déposé dans une couche de revêtement (9) sur le substrat (8), sachant que, rapporté aux quantités molaires, Al et Si représentent au moins 2/3 des composants de nitrure de la couche.

12. Procédé selon la revendication 11, selon lequel le substrat (8) est porté à une température élevée, avant ou pendant l'application du revêtement.
